## Europäisches Patentamt
## European Patent Office
## Office européen des brevets

(19)

(11) Veröffentlichungsnummer: **0 303 092 B1**

(12) # EUROPÄISCHE PATENTSCHRIFT

(45) Veröffentlichungstag der Patentschrift: **15.12.93**

(51) Int. Cl.⁵: **G01R 27/02**, G01R 35/00

(21) Anmeldenummer: **88111979.6**

(22) Anmeldetag: **25.07.88**

(54) **Verfahren zur Messung von Widerständen, insbesondere der Widerstände von Teilnehmeranschlussleitungen eines digitalen Zeitmultiplex-Fernmeldenetzes.**

(30) Priorität: **12.08.87 DE 3726882**

(43) Veröffentlichungstag der Anmeldung:
**15.02.89 Patentblatt 89/07**

(45) Bekanntmachung des Hinweises auf die Patenterteilung:
**15.12.93 Patentblatt 93/50**

(84) Benannte Vertragsstaaten:
**AT BE CH DE FR GB IT LI NL SE**

(56) Entgegenhaltungen:
**US-A- 4 335 349**
**US-A- 4 337 517**

**FUNKSCHAU, No. 7, 1982, pages 61-63, München, DE; K. Jessen: "Elektronisch kalibriert"**

**PATENT ABSTRACTS OF JAPAN, vol. 7, no. 125 (P-200)(1270), 31 May 1983; & JP-A-58041365**

**TOUTE L'ELECTRON., no. 439, January 1979, pages 19-28; "Les voltmetres "systeme""**

(73) Patentinhaber: **SIEMENS AKTIENGESELL-SCHAFT**
**Wittelsbacherplatz 2**
**D-80333 München(DE)**

(72) Erfinder: **Kaiser, Wolfgang, Ing.-grad.**
**Appenzellerstrasse 113**
**D-8000 München 71(DE)**
Erfinder: **Schmutzler, Werner**
**Asambogen 24 b**
**D-8080 Fürstenfeldbruck(DE)**

EP 0 303 092 B1

EP 0 303 092 B1

**Beschreibung**

Die Erfindung betrifft ein Verfahren gemäß dem Oberbegriff des Patentanspruchs 1.

Im Zuge eines derartigen Verfahrens ist es erforderlich, den Meßkreis zumindest bei seiner Installation abzugleichen und zwar für einen Nullwert und für den Endwert. Solche Abgleiche sind jeweils zu wiederholen, wenn eine Prüfeinrichtung, deren Bestandteil der Meßkreis ist, einer Wartung unterzogen worden ist. Bisher wurden solche Abgleiche manuell durch Einschalten von Potentiometern vorgenommen. Um dem Temperaturgang und der Alterung von Bauteilen des Meßkreises zu begegnen, wurden bisher einerseits hochwertige Bauteile eingesetzt, andererseits zusätzliche Bauteile zur Durchführung von Kompensationsmaßnahmen verwendet.

Es ist auch schon eine Meßanordnung bekannt (US-A-4 337 517), bei der eine Kalibrierung selbsttätig vorgenommen wird. Es werden hierzu 16 gesonderte Messungen an verschiedenen Schaltungspunkten der Meßeinrichtung vorgenommen, die entsprechenden Meßwerte werden gespeichert und dann für den Kalibrierungsvorgang verwendet. Eine derartige Prozedur ist selbstverständlich auch dann noch sehr aufwendig, wenn sie, wie in der Entgegenhaltung vorgeschlagen, nur nach jeder hundertsten bis jeder tausendsten Messung vorgenommen wird.

Die Aufgabe der Erfindung besteht darin, ein Verfahren zur Messung von Widerständen der eingangs genannten Art dahingehend auszugestalten, daß die vorerwähnten Probleme des Abgleichs und des Einflusses von Temperaturgang und Alterung der Meßkreisbauteile auf günstigere Art und Weise bewältigt werden können als bisher.

Diese Aufgabe wird mit einem Verfahren der eingangs genannten Art gelöst, das die im Kennzeichen des Patentanspruchs 1 angegebenen Merkmale aufweist.

Aufgrund der erfindungsgemäßen Maßnahmen erübrigen sich manuelle Abgleiche, stattdessen werden zu Beginn jeder eigentlichen Widerstandsmessung zwei zusätzliche Messungen vorgenommen, deren Ergebnisse zur Bildung eines Bewertungsfaktors herangezogen werden. Die Wichtung der bei der eigentlichen Widerstandsmessung vom Meßkreis gelieferten Spannung mit diesem Wertungsfaktor ersetzt jedoch nicht nur einen Abgleich des Meßkreises, sie hat vielmehr auch zur Folge, daß der Meßwert unabhängig von Temperaturgang und Alterung der Bauteile des Meßkreises ist.

Nachstehend wird die Erfindung anhand eines Ausführungsbeispiels unter Bezugnahme auf eine Zeichnung näher erläutert.

In der Zeichnung zeigen:

FIG 1 das Schaltbild einer Anordnung zur Durchführung des erfindungsgemäßen Verfahrens,

FIG 2 ein Ersatzschaltbild des Meßkreises der Anordnung gemäß FIG 1.

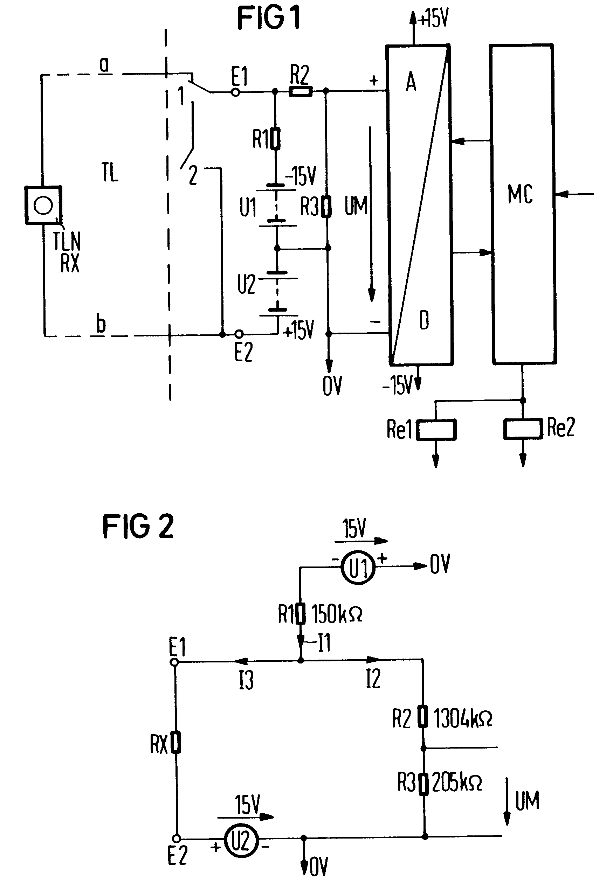

Die in FIG 1 dargestellte Schaltungsanordnung zur Durchführung des erfindungsgemäßen Verfahrens steht im Zusammenhang mit der Messung des Widerstandes einer Teilnehmeranschlußleitung TL mit den Adern a und b samt angeschlossenem Teilnehmerendgerät TLN, die auf der linken Seite der Figur dargestellt sind.

Der eigentliche Meßkreis der dargestellten Anordnung besteht aus der Reihenschaltung eines Widerstandes R1 und zwei Spannungsquellen U1 und U2, die jeweils eine Spannung von 15 V liefern. Die Adern a und b der Teilnehmeranschlußleitung sind an die Eingänge E1 und E2 dieses Meßkreises angeschlossen.

Die über dem Widerstand R1 abfallende Spannung wird als Ausgangsspannung des Meßkreises abgenommen, wobei der Verbindungspunkt der Spannungsquellen U1 und U2 als Bezugspunkt dient. Sie wird mittels eines aus den Widerständen R2 und R3 bestehenden Spannungsteilers, der mit seinem einen Anschluß an den Anschluß E1 des Meßkreises und mit seinem anderen Anschluß an den Bezugspunkt angeschlossen ist, auf einen Wert reduziert, der dem Arbeitsbereich eines nachgeschalteten Analog-Digital Wandlers A/D entspricht. Der Eingang (+) des Analog-Digital-Wandlers A/D ist an den Teilerpunkt des Spannungsteilers angeschlossen, der Eingang (-) an den erwähnten Bezugspunkt. Aufgrund der Wahl des Verbindungspunktes der Spannungsquellen U1 und U2 als Bezugspunkt wird erreicht, daß der gesamte Arbeitsbereich des Analog-Digital-Wandlers A/D ausgenutzt werden kann.

Dem Analog-Digital-Wandler A/D ist ein digitaler Signalprozessor Form eines Mikroprozessors MC nachgeschaltet, der die vom Meßkreis kommenden Meßwerte verarbeitet und durch Beeinflussung von Relais Re1 und Re2 den Meßkreis steuert.

Über den Umschaltekontakt 1 des Relais Re1 ist der Meßkreiseingang E1 mit der a-Ader der Teilnehmeranschlußleitung TL verbindbar. Er dient in seiner anderen Schaltstellung dazu, zusammen mit dem geschlossenen Kontakt 2 des Relais Re2 den Meßkreis eingangsseitig über den Anschlüssen E1 und E2 kurzzuschließen.

Die FIG 2 zeigt ein Ersatzschaltbild des beschriebenen Meßkreises zusammen mit dem erwähnten Spannungsteiler R2/R3 und dem zu messenden Widerstand fix der Teilnehmeranschlußleitung TL mit

2

angeschlossenem Teilnehmerendgerät TLN. Anhand dieses Schaltbildes werden die Zusammenhänge zwischen der über dem Spannungsteilerwiderstand R3 abgegriffenen und dem Analog-Digital-Wandler A/D zugeführten Meßspannung UB und dem zu messenden Widerstand fix offensichtlich. Es gelten demnach:

1. $-U1 + U2 + I1 \cdot R1 + I3 \cdot Rx = 0$

2. $-U1 + I1 \cdot R1 + I2(R2 + R3) = 0$

3. $I2 = I1 - I3$

4. $UM = I2 \cdot R3$

Aus 1. bis 4. folgt dann:

5.

$$UM = R3 \cdot \frac{U1 \cdot Rx + U2 \cdot R1}{Rx(R1 + R2 + R3) + R1(R2 + R3)} [V]$$

Bei einer realisierten Ausführungsform gilt: R1 = 150 kOhm, R2 = 1304 kOhm, R3 = 205 kOhm, U1 und U2 = 15 V. Es ergibt sich daraus folgende Übertragungsfunktion:

$$UM = 205 \cdot 15 \cdot \frac{150 - Rx}{Rx \cdot 1659 + 226350} [V]$$

Nachstehend wird auf die Durchführung des erfindungsgemäßen Verfahrens unter Verwendung der in FIG 1 dargestellten Anordnung näher eingegangen.

Erfindungsgemäß wird vor jeder eigentlichen Widerstandsmessung eine Messung bei leerlaufendem Meßkreis vorgenommen, wozu aufgrund eines Steuerbefehls des Signalprozessors an das Relais Re1 mittels des Kontaktes 1 die a-Ader vom Meßkreiseingang E1 abgetrennt wird. Es wird ferner eine Messung bei kurzgeschlossenem Meßkreiseingang vorgenommen, wozu durch entsprechende Steuerbefehle an beide Relais Re1 und Re2 die Kontakte 1 und 2 in die jeweils andere als die dargestellte Schaltstellung gebracht werden. Die dabei jeweils vom Meßkreis gelieferten Meßspannungen UM werden nach einer Analog-Digital-Wandlung durch den Analog-Digital-Wandler A/D dem digitalen Signalprozessor MC zugeführt, der daraus die Differenz UM ∞ -UMO bildet. Dieser Differenzwert ist der nullpunktkorrigierte Wert der Meßspannung bei Leerlauf des Meßkreiseingangs. Unter Anwendung der obengenannten Gleichung 5 ergibt sich rein rechnerisch für diesen Wert der Zusammenhang:

$$UM = \frac{U1 \cdot R3}{R1 + R2 + R3} - \frac{U2 \cdot R3}{R2 + R3} [V] .$$

Der Digitalsignalprozessor bildet nun außerdem einen Bewertungsfaktor, der der Quotient aus dem rechnerischen Nullpunkt korrigierten Spannungswert UM bei leerlaufendem Meßkreiseingang und dem vorgenannten gemessenen Wert dieser Differenzspannung ist.

Es beginnt nunmehr die eigentliche Messung des Widerstandes der Teilnehmeranschlußleitung TL mit angeschaltetem Teilnehmerendgerät TLN, wozu die Kontakte 1 und 2 in die dargestellte Stellung gebracht werden. Der dabei am Ausgang des Meßkreises auftretende Spannungswert UM wird nach einer Analog-Digital Wandlung gespeichert, daraufhin wird durch den Signalprozessor MC der Differenzwert dieses Spannungswertes und des im Zuge des Schrittes 1 erhaltenen Spannungswertes bei kurzgeschlossenem Meßkreiseingang gebildet. Dieser Differenzwert wird daraufhin mit dem Bewertungsfaktor multipliziert.

Schließlich wird der solcherart bewertete Spannungswert entsprechend dem durch die Gleichung 5 gegebenen Zusammenhang in einen Widerstandswert umgerechnet und ausgegeben. Dieser Widerstandswert wird ausgegeben und angezeigt, womit, die Meßprozedur abgeschlossen ist.

**Patentansprüche**

**1.** Verfahren zur Messung von Widerständen, insbesondere der Widerstände von Teilnehmeranschlußleitungen (TL) eines digitalen Zeitmultiplex-Fernmeldenetzes unter Verwendung eines Spannungsquellen (U1, U2) und Widerstände (R1, R2, R3) enthaltenden Meßkreises, dessen Eingang (E1, E2) über steuerbare Kontakte (11, 2) wahlweise kurzschließbar, mit dem zu messenden Widerstand (Rx) verbindbar oder für Leerlauf abtrennbar ist, und eines Signalprozessors (MC), der die Kontakte (1, 2)

3

steuert und aus vom Meßkreis gelieferten Spannungswerten (UM) die Widerstandswerte ermittelt, **dadurch gekennzeichnet,** daß eine Messung bei leerlaufendem und eine Messung bei kurzgeschlossenem Meßkreiseingang (E1, E2) vorgenommen wird, daß aus der Differenz der dabei vom Meßkreis gelieferten Spannungswerte (UM) und der Differenz der entsprechenden, unter Heranziehung der vorgegebenen Meßkreis dimensionierung rechnerisch ermittelten Spannungswerte durch Quotientenbildung ein Bewertungsfaktor gebildet wird, und daß der Differenzwert aus dem bei mit dem zu messenden Widerstand (Rx) verbundenen Meßkreiseingang (E1, E2) und dem genannten, bei kurzgeschlossenem Meßkreiseingang (E1, E2) gelieferten Spannungswert (UM) mit dem Bewertungsfaktor gewichtet und danach in den Widerstandswert des gemessenen Widerstandes (Rx) umgerechnet wird.

2. Verfahren nach Anspruch 1, **dadurch gekennzeichnet,** daß als Signalprozessor ein digitaler Signalprozessor (MC) verwendet wird, dem die vom Meßkreis (R1, U1, U2; R2, R3) gelieferten Spannungswerte (UM) nach einer Analog-Digital-Wandlung (A/D) zugeführt werden.

## Claims

1. Method for measuring resistances, particularly the resistances of subscriber lines (TL) of a digital time-division multiplex telecommunication network, using a measuring circuit containing voltage sources (U1, U2) and resistors (R1, R2, R3), the input (E1, E2) of which circuit can be optionally short-circuited, connected to the resistance (Rx) to be measured or disconnected for open circuit via controllable contacts (1, 2), and a signal processor (MC) which controls the contacts (1, 2) and determines the resistance values from the voltage values (UM) supplied by the measuring circuit, characterized in that one measurement is taken with the measuring circuit input (E1, E2) idling and one measurement is taken with it short-circuited, in that a weighting factor is formed by forming quotients from the difference of the voltage values (UM) supplied by the measuring circuit during this process and the difference of the corresponding voltage values determined mathematically by using the predetermined measuring circuit dimensioning, and in that the difference value from the measuring circuit input (E1, E2) connected to the resistance (Rx) to be measured and the said voltage value (UM) supplied with the measuring circuit input (E1, E2) short-circuited is weighted with the weighting factor and then recalculated into the resistance value of the measured resistance (Rx).

2. Method according to Claim 1, characterized in that a digital signal processor (MC), which is supplied, after analog/digital conversion (A/D), with the voltage values (UM) supplied by the measuring circuit (R1, U1, U2; R2, R3), is used as signal processor.

## Revendications

1. Procédé pour mesurer des résistances, notamment les résistances de lignes d'abonnés (TL) d'un réseau numérique de télécommunication à multiplexage temporel, moyennant l'utilisation d'un circuit de mesure qui comporte des sources de tension (U1, U2) et des résistances (R1, R2, R3) et dont l'entrée (E1, E2) peut être court-circuitée au choix par l'intermédiaire de contacts (11, 2) commandables, peut être reliée à la résistance (Rx) à mesurer ou en être séparée pour un fonctionnement à vide, et moyennant l'utilisation d'un processeur de signaux (MC), qui commande les contacts (1,2) et qui détermine les valeurs des résistances à partir de valeurs de tension (UM) fournies par le circuit de mesure,
caractérisé par le fait
qu'une mesure est effectuée lorsque l'entrée (E1, E2) du circuit de mesure fonctionne à vide et qu'une mesure est effectuée lorsque l'entrée (E1, E2) du circuit de mesure est court-circuitée, qu'un facteur de pondération est formé à partir de la différence entre les valeurs de tension (UM) fournies par le circuit de mesure et à partir de la différence entre les valeurs de tension correspondantes déterminées par calcul, moyennant l'utilisation du dimensionnement prédéterminé du circuit de mesure, par formation d'un quotient, et que la valeur de différence est pondérée par le facteur de pondération à partir de la valeur de tension (UM) fournie lorsque l'entrée (E1,E2) du circuit de mesure est reliée à la résistance à mesurer (Rx), et à partir de ladite la valeur de tension (UM) délivrée lorsque l'entrée (E1, E2) du circuit de mesure est court-circuitée, et est ensuite convertie en la valeur résistive de la résistance mesurée (Rx).

2. Procédé suivant la revendication 1, caractérisé par le fait qu'on utilise, comme processeur de signaux, un processeur numérique de signaux (MC), auquel les valeurs de tension (UM) fournies par le circuit de mesure (R1, U1, U2; R2, R3) sont envoyées après une conversion analogique/numérique (A/D).

FIG 1

FIG 2